# EUROPEAN PATENT APPLICATION

(11) **EP 4 538 727 A1**
(43) Date of publication of application: **16.04.2025**
(21) Application number: 24816902.1
(22) Date of filing: 09.08.2024
(51) Int. Cl.: G01R 31/378, H01M 10/48

(54) **SECONDARY BATTERY INFORMATION OUTPUT DEVICE**

(30) Priority: 29.08.2023 JP 2023139316
(71) Applicant: Toyo System Co., Ltd., Iwaki-shi, Fukushima 972-8316 (JP)
(72) Inventor: HASEGAWA, Takamasa, Iwaki-shi, Fukushima 972-8316 (JP); SHOJI, Hideki, Iwaki-shi, Fukushima 972-8316 (JP)
(74) Representative: Schön, Christoph
(86) International application number: PCT/JP2024/028732
(87) International publication number: WO 2025/047392

(57) **Abstract**

Provided is a secondary battery information output device capable of easily estimating characteristics of a secondary battery. The secondary battery information output device includes a data acquisition element configured to acquire charging and discharging data, a storage element configured to store first correspondence relationship data and second correspondence relationship data, an information processing element configured to estimate a type of a secondary battery of a processing target, and an output element configured to output an estimation result of the information processing element. The information processing element executes first estimation processing of estimating the type of the secondary battery of the processing target, and executes second estimation processing of further estimating the type of the secondary battery of the processing target when the type of the secondary battery of the processing target is not able to be uniquely estimated in the first estimation processing.

## Description

### Technical Field

The present invention relates to a device that outputs information on a secondary battery.

### Background Art

In a case of carrying out the maintenance of a secondary battery, in a case of attempting to reuse the used secondary battery, or the like, a deterioration state of the secondary battery is determined. The deterioration state of the secondary battery can be estimated, for example, from a voltage value of the secondary battery (for example, Patent Literature 1).

### Citation List

### Patent Literature

Patent Literature 1: Japanese Patent No. 7266907

### Summary of Invention

### Technical Problem

However, a correspondence relationship between the voltage value of the secondary battery and the deterioration state varies depending on characteristics of the secondary battery. Then, it is desirable to know, for example, a model of the secondary battery as information for specifying the characteristics of the secondary battery, but the information on the model of the secondary battery may not be acquired.

Even in such a case, there is a need to perform the deterioration determination of the secondary battery after specifying the characteristics of the secondary battery of a determination target of a deterioration target to some extent, but the technique of Patent Literature 1 is not able to meet the need. Therefore, there is a demand for a technique capable of easily estimating the characteristics of the secondary battery.

Therefore, an object of the present invention is to provide a secondary battery information output device capable of easily estimating characteristics of a secondary battery.

### Solution to Problem

A secondary battery information output device of the present invention including:
a data acquisition element configured to acquire charging and discharging data configured of data of a first voltage value before charging or before discharging and data of a second voltage value after start of charging or discharging of a secondary battery of a processing target;
a storage element configured to store first correspondence relationship data indicating a correspondence relationship between the first voltage value of the secondary battery and a type of the secondary battery, and second correspondence relationship data indicating a correspondence relationship between a change in a voltage value between the first voltage value and the second voltage value of the secondary battery, and the type of the secondary battery;
an information processing element configured to estimate the type of the secondary battery of the processing target based on the charging and discharging data, the first correspondence relationship data, and the second correspondence relationship data; and
an output element configured to output an estimation result of the information processing element, in which
the information processing element is configured to
   execute first estimation processing of estimating the type of the secondary battery of the processing target based on the data of the first voltage value of the secondary battery of the processing target and the first correspondence relationship data, and
   further execute second estimation processing of estimating the type of the secondary battery of the processing target based on the change in the voltage value between the first voltage value and the second voltage value, and the second correspondence relationship data, when the type of the secondary battery of the processing target is not able to be uniquely estimated in the first estimation processing.

The inventors have obtained a finding that the characteristics of the secondary battery can be specified to some extent by specifying the type of the secondary battery (for example, the type of the secondary battery based on a difference between a positive electrode active material and a negative electrode active material). More specifically, the configurations are as follows.
(1) The type of the secondary battery may be specified by a voltage value (so-called open circuit voltage (OCV)) before charging or discharging the secondary battery.
(2) Even in a case where the type of the secondary battery cannot be specified by the voltage value before charging or before discharging the secondary battery, that is, for example, in a case where the ranges of the voltage values before charging or before discharging overlap each other in a plurality of different types of secondary batteries, the type of the secondary battery can be specified to some extent depending on the way of change between the voltage value before charging or before discharging, and the voltage value after the start of charging or discharging.

The present invention is based on the novel findings, and the data acquisition element acquires the charging and discharging data configured of the data of the first voltage value that is a value of the voltage before charging or before discharging, and the data of the second voltage value that is a value of the voltage after the start of charging or discharging of the secondary battery of a processing target.

The information processing element performs estimation of the type of the secondary battery of the processing target based on the first correspondence relationship data indicating the correspondence relationship between the first voltage value of the secondary battery and the type of the secondary battery, and the first voltage value of the secondary battery of the processing target, and further performs estimation of the type of the secondary battery of the processing target based on the second correspondence relationship data indicating the correspondence relationship between the change in the voltage value between the first voltage value and the second voltage value and the type of the secondary battery, and the change in the voltage value between the first voltage value and the second voltage value of the secondary battery of the processing target, when the type of the secondary battery of the processing target cannot be uniquely estimated in the first voltage value.

As a result, in a case where the type of the secondary battery can be uniquely estimated by the first voltage value, the type of the secondary battery can be estimated with a small number of processing steps.

In a case where the type of the secondary battery cannot be uniquely estimated only with the first voltage value, further, the estimation of the type of the secondary battery is automatically performed using the change in the voltage value between the first voltage value and the second voltage value, so that the reliability of estimating the type of the secondary battery is increased.

In addition, since the information used for estimating the type of the secondary battery is only the voltage value before and after charging or discharging the secondary battery, the type of the secondary battery can be easily estimated.

As described above, according to the present invention, the type of the secondary battery can be easily estimated as the characteristics of the secondary battery.

In the present invention, it is preferable that
the storage element stores manufacturer data indicating a correspondence relationship between the type of the secondary battery and a manufacturer of the secondary battery,
the information processing element estimates the manufacturer of the secondary battery of the processing target based on the estimated type of the secondary battery of the processing target and the manufacturer data, and
the output element outputs information on the manufacturer of the secondary battery of the processing target estimated by the information processing element.

Even in a case where the type of the secondary battery is the same, the characteristics of the secondary battery may vary depending on the manufacturer. In order to further narrow down the characteristics of the secondary battery, it is preferable to also obtain information on the manufacturer of the secondary battery.

According to the present invention, the information processing element estimates the manufacturer of the secondary battery of the processing target based on manufacturer data indicating a correspondence relationship between the type of the secondary battery and the manufacturer of the secondary battery and the estimated type of the secondary battery, and the output element outputs the estimation result. According to the present invention, it is possible to further estimate the manufacturer of the secondary battery as the characteristics of the secondary battery.

In the present invention, it is preferable that the secondary battery information output device further includes
a reception element configured to receive an operation of an operator of the secondary battery information output device, in which
the output element outputs information on a plurality of the manufacturers estimated by the information processing element when the information processing element is not able to uniquely estimate the manufacturer of the secondary battery of the processing target, and
the information processing element
   receives an operation of the operator to select one manufacturer from the plurality of manufacturers via the reception element, and
   estimates that the manufacturer that is received is the manufacturer of the secondary battery of the processing target.

According to the present invention, in a case where the information processing element cannot uniquely estimate the manufacturer of the secondary battery of the processing target, the output element outputs information on a plurality of the manufacturers estimated by the information processing element. Then, the information processing element receives an operation of selecting one manufacturer from a plurality of manufacturers by the operator, and estimates that the received manufacturer is the manufacturer of the secondary battery of the processing target.

As a result, even in a case where the manufacturer of the secondary battery cannot be uniquely estimated only with the type of the secondary battery, the reliability of estimating the manufacturer of the secondary battery is increased through the dialogue with the operator.

In the present invention, it is preferable that
the storage element stores on-board device data indicating a correspondence relationship between the manufacturer of the secondary battery and an on-board device of the secondary battery,
the information processing element estimates the on-board device of the secondary battery of the processing target based on the estimated manufacturer of the secondary battery of the processing target and the on-board device data, and
the output element outputs information on the on-board device of the secondary battery of the processing target estimated by the information processing element.

Even in a case where the type and manufacturer of the secondary battery are the same, the characteristics of the secondary battery may vary depending on which device the secondary battery is mounted on, that is, which device the secondary battery is manufactured for. In order to further narrow down the characteristics of the secondary battery, it is preferable that the secondary battery also obtains the information on the on-board device.

According to the present invention, the information processing element estimates the on-board device of the secondary battery of the processing target based on the on-board device data indicating the correspondence relationship between the manufacturer of the secondary battery and the on-board device of the secondary battery and the estimated manufacturer of the secondary battery, and the output element outputs the estimation result. According to the present invention, it is possible to further estimate the on-board device of the secondary battery as the characteristics of the secondary battery.

In the present invention, it is preferable that the secondary battery information output device further includes
a reception element configured to receive an operation of an operator of the secondary battery information output device, in which
the output element outputs information on a plurality of the devices estimated by the information processing element when the information processing element is not able to uniquely estimate the on-board device of the secondary battery of the processing target, and
the information processing element
   receives an operation of the operator to select one device from the plurality of devices via the reception element, and
   estimates that the device that is received is the on-board device of the secondary battery of the processing target.

According to the present invention, in a case where the information processing element cannot uniquely estimate the on-board device of the secondary battery of the processing target, the output element outputs information on a plurality of devices estimated by the information processing element. Then, the information processing element receives an operation of selecting one device from a plurality of devices by the operator, and estimates that the received device is the on-board device of the secondary battery of the processing target.

As a result, even in a case where the on-board device cannot be uniquely estimated only by the manufacturer of the secondary battery, the reliability of estimating the on-board device of the secondary battery is increased through the dialogue with the operator.

### Brief Description of Drawings

FIG. 1 is a block diagram illustrating an example of an overall image of a secondary battery information output device of the present invention.
FIG. 2 is a diagram illustrating an example of contents of data used in processing of the present invention.
FIG. 3 is a diagram illustrating an example of contents of data used in processing of the present invention.
FIG. 4 is a diagram illustrating an example of contents of data used in processing of the present invention.
FIG. 5 is a flowchart illustrating an example of processing contents of the present invention.
FIG. 6 is a diagram illustrating an example of contents of data used in processing of the present invention.
FIG. 7 is a flowchart illustrating a modified embodiment of processing contents of the present invention.
FIG. 8 is a flowchart illustrating a modified embodiment of processing contents of the present invention.
FIG. 9 is a flowchart illustrating a modified embodiment of processing contents of the present invention.
FIG. 10 is a diagram illustrating an example of output content of the present invention.
FIG. 11 is a diagram illustrating an example of contents of data used in processing of the present invention.
FIG. 12 is a diagram illustrating an example of output content of the present invention.

### Description of Embodiments

### <Configuration of secondary battery information output device>

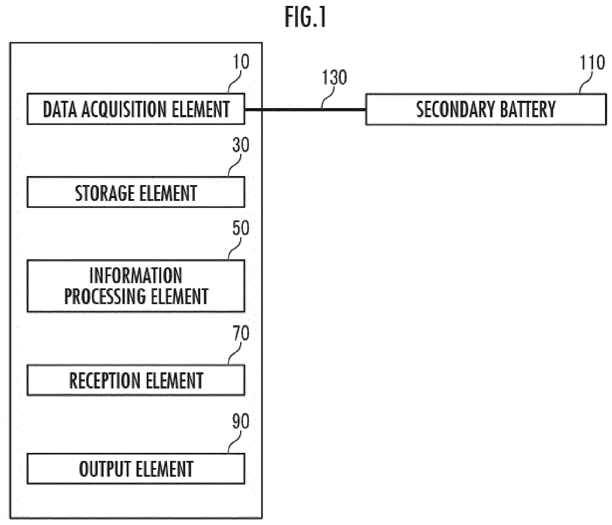

First, a configuration of a secondary battery information output device according to the present embodiment will be described with reference to FIG. 1. The same configurations are denoted by the same reference numerals, and the description thereof will not be repeated.

The secondary battery information output device of the present embodiment is a device that outputs information on a secondary battery.

The secondary battery information output device of the present embodiment is, for example, a computer that is configured to include a data acquisition element 10, a storage element 30, and an information processing element 50. Alternatively, the secondary battery information output device may be configured to further include a reception element 70. The secondary battery information output device may be mounted on, for example, a general-purpose computer such as a personal computer, a tablet, or a smartphone, or may be mounted on a terminal dedicated to the implementation of the present invention.

The data acquisition element 10 is a mechanism that acquires charging and discharging data configured of data of a first voltage value, which is a voltage value before charging or before discharging, and data of a second voltage value, which is a voltage value after start of charging or discharging of a secondary battery 110 of a processing target.

The data acquisition element 10 is, for example, a voltmeter that acquires the voltage value of the secondary battery 110 of the processing target, but various known means for acquiring the voltage value of the secondary battery may be used as the data acquisition element 10. In a case where the data acquisition element 10 is the voltmeter, for example, the voltage value is acquired from the secondary battery 110 of the processing target via a cable 130 including a terminal for acquiring the voltage value of the secondary battery 110. In addition, only one cable is illustrated in the drawing for simplification of description, but the number of cables required for acquiring the voltage value may be used.

Alternatively, for example, the data acquisition element 10 may acquire charging and discharging data of the secondary battery 110 of the processing target by reading the charging and discharging data acquired from the secondary battery 110 of the processing target by the voltmeter (not illustrated) or the like in advance and stored in storage means (not illustrated) by the storage means.

The storage element 30 is configured by a storage device such as a read only memory (ROM), a random access memory (RAM), or a hard disk drive (HDD).

The storage element 30 stores a processing result of the secondary battery information output device of the present embodiment and information used for the processing, in addition to first correspondence relationship data and second correspondence relationship data. The information used in the processing by the secondary battery information output device according to the present embodiment is, for example, charging and discharging data, manufacturer data, and on-board device data.

The charging and discharging data is data configured of data of the first voltage value which is a voltage value before charging or discharging and data of the second voltage value which is a voltage value after start of charging or discharging of the secondary battery 110 of the processing target.

The "before charging" does not mean only a state where a discharging capacity of the secondary battery 110 of the processing target is 0 (that is, a state where the state of charge (SOC) is 0%), but may be any state between a state where the discharging capacity is 0 and a state where the secondary battery 110 is completely charged. That is, the voltage value before charging or before discharging is a voltage value in a state where the secondary battery 110 of the processing target is neither charged nor discharged, regardless of the state of the SOC of the secondary battery 110 of the processing target.

That is, the first voltage value is a so-called open-circuit voltage value of the secondary battery 110 of the processing target. The second voltage value is a voltage value acquired while the secondary battery 110 of the processing target is discharging (or charging).

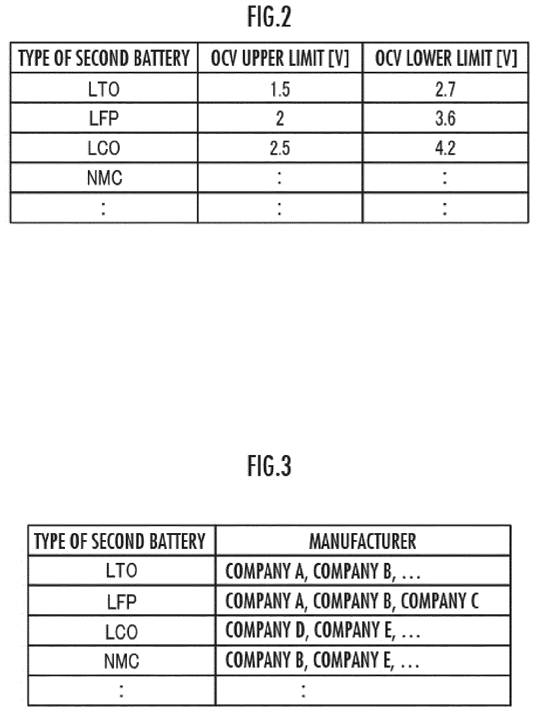

The first correspondence relationship data is data indicating a correspondence relationship between the first voltage value of the secondary battery and the type of the secondary battery. FIG. 2 illustrates an example of the content of the first correspondence relationship data. As illustrated in FIG. 2, in the first correspondence relationship data, each type of a plurality of secondary batteries and values of an upper limit (OCV upper limit) and a lower limit (OCV lower limit) of the first voltage value, that is, information on a range in which the first voltage value can be taken, are stored in association with each other.

In addition, the type of the secondary battery is, for example, a type of the secondary battery characterized by the type of the positive electrode active material and the type of the negative electrode active material used in the battery.

The second correspondence relationship data is data indicating a correspondence relationship between a change in a voltage value between the first voltage value and the second voltage value of the secondary battery, and the type of the secondary battery. The specific content of the second correspondence relationship data will be described later.

The manufacturer data is data indicating a correspondence relationship between the type of the secondary battery and a manufacturer of the secondary battery. That is, for example, as illustrated in FIG. 3, the manufacturer data stores each type of the secondary battery included in the first correspondence relationship data and a name of a manufacturer that manufactures, sells, or the like the secondary battery of the type in association with each other.

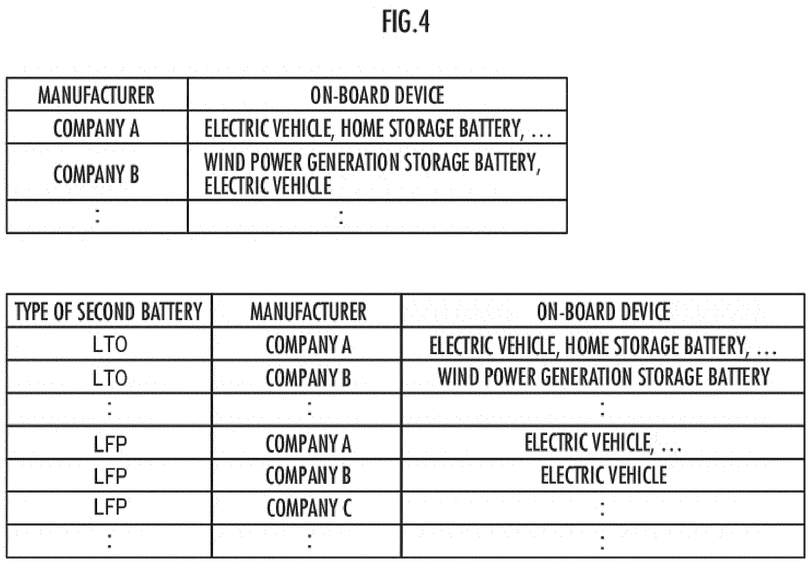

The on-board device data is data indicating a correspondence relationship between the manufacturer of the secondary battery and the on-board device of the secondary battery. For example, as illustrated in an upper part of FIG. 4, the on-board device data stores the name of the manufacturer that manufactures, sells, or the like the secondary battery, and the type of the device on which the secondary battery of the manufacturer can be mounted, which are included in the manufacturer data, in association with each other.

Alternatively, as illustrated in a lower part of FIG. 4, for example, the on-board device data stores each combination of the type of the secondary battery included in the charging and discharging data and the name of the manufacturer that manufactures, sells, or the like the secondary battery, and the like included in the manufacturer data, and the type of the device, which is specified by the combination and on which the secondary battery can be mounted, in association with each other.

The information processing element 50 is a so-called processor configured of a computing processing device such as a central processing unit (CPU), a memory, an input/output (I/O) device, and the like.

The information processing element 50 executes various types of processing performed by the secondary battery information output device by reading and executing a predetermined program.

The reception element 70 is, for example, a keyboard, a touch panel, or a mouse, which receives an input from the user, or another pointing device.

The output element 90 is, for example, a display that outputs information to the user.

The secondary battery 110 is a variety of batteries corresponding to on-board batteries for electric vehicles, batteries for home storage batteries, electric transport devices (carts, forklifts, and the like), personal computers, and on-board devices such as mobile phones, and is, for example, a lithium ion battery, but may be other various types of secondary batteries.

### <Overview of processing>

### · Data acquisition processing

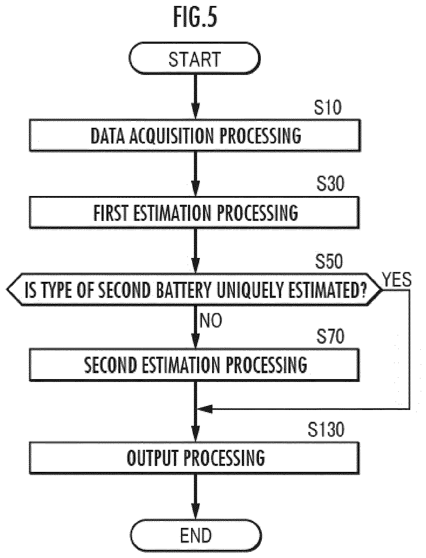

Next, processing content of the secondary battery information output device according to the present embodiment will be described. First, a series of processing by the secondary battery information output device will be described with reference to FIG. 5.

When the processing is started, the data acquisition element 10 executes data acquisition processing of acquiring charging and discharging data configured of data of the first voltage value before charging or before discharging and data of the second voltage value after start of charging or discharging of the secondary battery 110 of the processing target (FIG. 5/S10).

The data acquisition element 10 in the present embodiment is a voltmeter, and acquires a voltage value from the secondary battery 110 of the processing target via the cable 130 including a terminal for acquiring the voltage value of the secondary battery 110.

For example, in the data acquisition processing, the data acquisition element 10 acquires the value of the voltage in a state where the secondary battery 110 of the processing target is not discharging (or charging) in time series, and after the secondary battery 110 of the processing target starts discharging (or charging), the data acquisition element 10 acquires the value of the voltage in time series while the secondary battery 110 of the processing target is discharging (or charging). The data acquisition element 10 stores these data in the storage element 30 as charging and discharging data, for example.

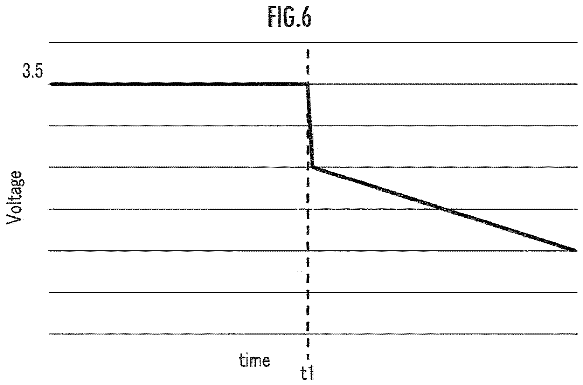

FIG. 6 is a graph illustrating an example of charging and discharging data acquired by the present processing. The horizontal axis indicates a time axis, and the vertical axis indicates a voltage value. In FIG. 6, the left side including the time point t1 indicates the data of the first voltage value, and the right side of the time point t1 indicates the data of the second voltage value. As described above, the data of the first voltage value and the data of the second voltage value are temporally continuous.

In addition, since FIG. 6 illustrates a change in the voltage value in a case where the discharging is started from a state where the secondary battery 110 of the processing target is not performing charging and discharging, the voltage value decreases on the right side of the time point t1. Therefore, in a case where charging is started from a state where the secondary battery 110 of the processing target is not performing charging and discharging, the voltage value increases on the right side of the time point t1.

### · First estimation processing

Next, first estimation processing (FIG. 5/S30) of estimating the type of the secondary battery 110 of the processing target is executed based on the data of the first voltage value of the secondary battery 110 of the processing target and the first correspondence relationship data.

When the processing is started, the information processing element 50 acquires, for example, the data of the first voltage value included in the charging and discharging data of the secondary battery 110 of the processing target, and the first correspondence relationship data, stored in the storage element 30.

Then, the information processing element 50 specifies the type of the secondary battery that matches the data of the first voltage value with reference to the first correspondence relationship data. That is, the information processing element 50 estimates the type of the secondary battery that matches the data of the first voltage value, depending on whether the voltage value indicated by the first correspondence relationship data is between the OCV upper limit and the OCV lower limit.

For example, since the first voltage value of the secondary battery 110 of the processing target illustrated in FIG. 6 is 3.5 [V], if the content of the first correspondence relationship data is the content illustrated in FIG. 2, it is estimated that the type of the secondary battery is "LFP" or "LCO".

In this case, for example, if the first voltage value of the secondary battery 110 of the processing target is 3.8 [V], "LCO" is uniquely estimated as the type of the secondary battery.

Thereafter, it is determined whether the type of the secondary battery 110 of the processing target can be uniquely estimated in the first estimation processing, and in a case where the type of the secondary battery 110 of the processing target cannot be uniquely estimated in the first estimation processing (FIG. 5/No in S50), the second estimation processing (FIG. 5/S70) is executed. On the other hand, in a case where the type of the secondary battery 110 of the processing target can be uniquely estimated in the first estimation processing (FIG. 5/Yes in S50), the second estimation processing (FIG. 5/S70) is not executed, and the output processing (FIG. 5/S130) is executed.

### · Second estimation processing

The second estimation processing is processing that is further executed in a case where the type of the secondary battery 110 of the processing target cannot be uniquely estimated in the first estimation processing, and is processing of estimating the type of the secondary battery 110 of the processing target based on the change in the voltage value between the first voltage value and the second voltage value, and the second correspondence relationship data.

when the second estimation processing is started, the information processing element 50 acquires, for example, the data of the second voltage value for a predetermined time included in the charging and discharging data of the secondary battery 110 of the processing target, and the second correspondence relationship data, stored in the storage element 30.

Then, the information processing element 50 specifies the type of the secondary battery that matches the change in the voltage value between the first voltage value and the second voltage value using the second correspondence relationship data. The first voltage value used in this case is the first voltage value acquired in the first estimation processing.

The second correspondence relationship data is various types of data indicating a correspondence relationship between the change in the voltage value between the first voltage value and the second voltage value of the secondary battery, and the type of the secondary battery, and for example, various types of data such as a correspondence table, a calculation expression, a function, and a determination model may be used.

Hereinafter, an example will be described in which the second correspondence relationship data is a learned model obtained by performing machine learning on a correspondence relationship between the change in voltage value between the first voltage value and the second voltage value of the secondary battery, and the type of the secondary battery, using, as learning data, reference data indicating the first voltage value and the second voltage value for a predetermined time, which are acquired from a plurality of sample secondary batteries corresponding to each type of the secondary battery recorded in the first correspondence relationship data, and data of the type of the sample secondary battery, and is a determination model that receives the first voltage value and the second voltage value at the predetermined time, which are acquired from the secondary battery 110 of the processing target, as an input and outputs a determination result of the type of the secondary battery 110 of the processing target.

In this case, the information processing element 50 inputs the first voltage value and the second voltage value at the predetermined time acquired from the secondary battery 110 of the processing target to the learned determination model which is the second correspondence relationship data. Then, the information processing element 50 estimates that the type of the secondary battery output by the determination model is the type of the secondary battery 110 of the processing target.

### · Output processing

Thereafter, the information processing element 50 executes the output processing of outputting the estimation result (FIG. 5/S130) to end the series of processing. The information processing element 50 outputs the estimation result obtained by the first estimation processing in a case where the second estimation processing is not executed, and outputs the estimation result obtained by the second estimation processing in a case where the second estimation processing is executed, to, for example, the display that is the output element 90. The operator can know the estimation result of the type of the secondary battery 110 of the processing target by viewing the output information.

Although an example of the embodiment of the present invention is described above, the present invention is not limited thereto. Various changes may be made without departing from the spirit of the present invention. Hereinafter, examples of modified embodiments of the present invention will be described.

### <Modified embodiment>

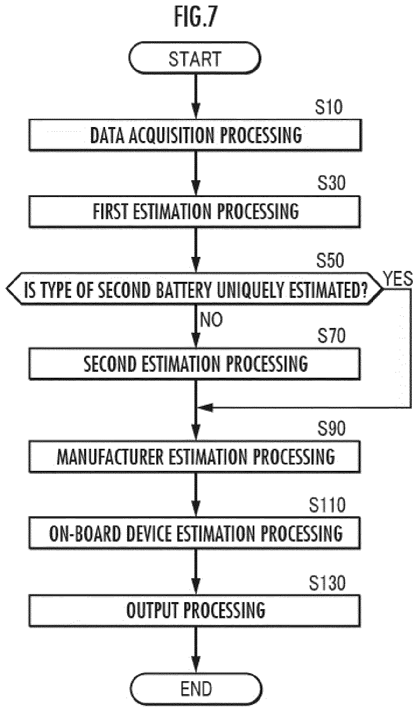

Hereinafter, a modified embodiment will be described in which the manufacturer estimation processing and the on-board device estimation processing are performed after the execution of the first estimation processing and the second estimation processing. Since the processing of S10 to S70 in FIG. 7 is the same as the above-described processing using FIG. 5, the description thereof will be omitted.

### · Manufacturer estimation processing

The manufacturer estimation processing (FIG. 7/S90) is processing of estimating the manufacturer of the secondary battery 110 of the processing target based on the type of the secondary battery 110 of the processing target estimated by the information processing element 50 in the first estimation processing or the second estimation processing, and the manufacturer data.

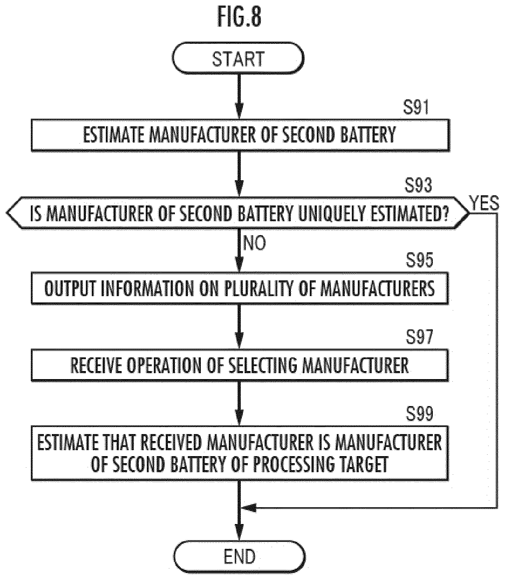

When the processing is started, the information processing element 50 estimates the manufacturer of the secondary battery 110 of the processing target with reference to the manufacturer data stored in the storage element 30 based on the type of the secondary battery 110 of the processing target estimated in the first estimation processing or the second estimation processing (FIG. 8/S91).

That is, for example, in a case where the manufacturer data is the correspondence table as illustrated in FIG. 3 and the estimated type of the secondary battery 110 of the processing target is LFP, it is estimated that "Company A", "Company B", and "Company C" stored in association with LFP may be the manufacturer of the secondary battery 110 of the processing target.

In this case, for example, if the manufacturer stored in association with the LFP is only Company A, "Company A" is uniquely estimated as the manufacturer of the secondary battery 110 of the processing target.

Thereafter, it is determined whether the manufacturer of the secondary battery 110 of the processing target can be uniquely estimated, and in a case where the manufacturer of the secondary battery 110 of the processing target cannot be uniquely estimated (FIG. 8/No in S93), the processing of S95 to S99 is executed. On the other hand, in a case where the manufacturer of the secondary battery 110 of the processing target can be uniquely estimated (FIG. 8/Yes in S93), the processing of S95 to S99 is not executed, and the manufacturer estimation processing ends.

In a case where the information processing element 50 cannot uniquely estimate the manufacturer of the secondary battery 110 of the processing target (FIG. 8/No in S93), the information processing element 50 first outputs a display that prompts the operator to select one manufacturer from among a plurality of manufacturers, together with the information on the plurality of manufacturers that are estimated to be the manufacturer of the secondary battery 110 of the processing target in S91, to the display that is the output element 90 (FIG. 8/S95).

Then, the information processing element 50 receives an operation of selecting one manufacturer from the plurality of manufacturers by the operator via the touch panel that is the reception element 70 (FIG. 8/S97), estimates that the received manufacturer is the manufacturer of the secondary battery of the processing target (FIG. 8/S99), and ends the manufacturer estimation processing.

### · On-board device estimation processing

The on-board device estimation processing (FIG. 7/S110) is processing of estimating the on-board device of the secondary battery 110 of the processing target based on the manufacturer of the secondary battery 110 of the processing target estimated by the information processing element 50 in the manufacturer estimation processing, and the on-board device data. This processing may be omitted.

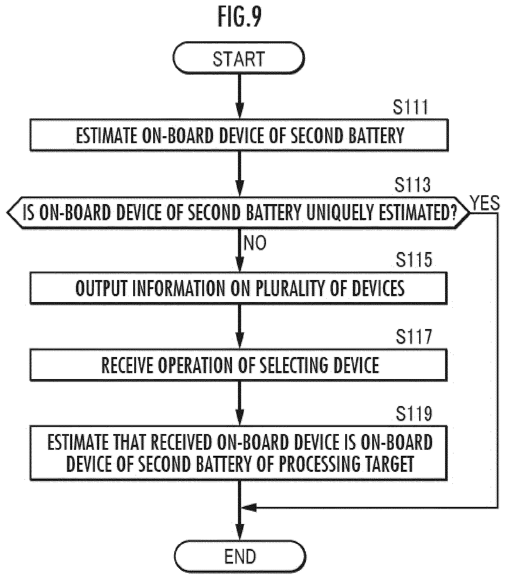

When the processing is started, the information processing element 50 estimates the on-board device of the secondary battery 110 of the processing target with reference to the on-board device data stored in the storage element 30 based on the manufacturer of the secondary battery 110 of the processing target estimated in the manufacturer estimation processing (FIG. 9/S111).

That is, for example, in a case where the on-board device data is the correspondence table as illustrated in the upper part of FIG. 4 and the manufacturer of the estimated secondary battery 110 of the processing target is Company B, it is estimated that "wind power generation storage battery" and "electric vehicle" stored in association with Company B may be the on-board device of the secondary battery 110 of the processing target.

In this case, for example, if the on-board device stored in association with Company B is only the electric vehicle, the "electric vehicle" is uniquely estimated as the on-board device of the secondary battery 110 of the processing target.

Alternatively, for example, in a case where the on-board device data is the correspondence table as illustrated in the lower part of FIG. 4, and if the type of the secondary battery 110 of the processing target estimated in the first estimation processing or the second estimation processing is LFP, and the manufacturer of the secondary battery 110 of the processing target estimated in the manufacturer estimation processing is Company B, the "electric vehicle" is uniquely estimated as the on-board device of the secondary battery 110 of the processing target.

Thereafter, it is determined whether the on-board device of the secondary battery 110 of the processing target can be uniquely estimated, and in a case where the on-board device of the secondary battery 110 of the processing target cannot be uniquely estimated (FIG. 9/No in S113), the processing of S115 to S119 is executed. On the other hand, in a case where the on-board device of the secondary battery 110 of the processing target can be uniquely estimated (FIG. 9/Yes in S113), the processing of S115 to S119 is not executed, and the on-board device estimation processing ends.

In a case where the information processing element 50 cannot uniquely estimate the on-board device of the secondary battery 110 of the processing target (FIG. 9/No in S113), the information processing element 50 first outputs a display that prompts the operator to select one device from among a plurality of devices, together with the information on the plurality of devices that are estimated to be the on-board device of the secondary battery 110 of the processing target in S111, to the display that is the output element 90 (FIG. 9/S115).

Then, the information processing element 50 receives an operation of selecting one device from the plurality of devices by the operator via the touch panel that is the reception element 70 (FIG. 9/S117), estimates that the received device is the on-board device of the secondary battery of the processing target (FIG. 9/S119), and ends the manufacturer estimation processing.

### · Output processing

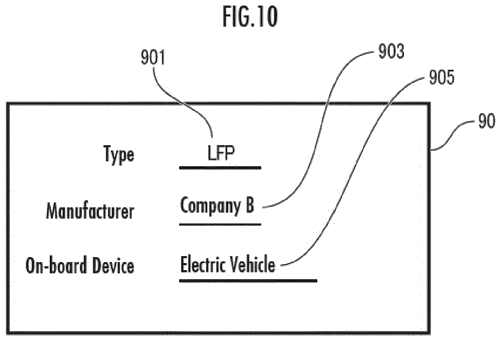

Thereafter, for example, as illustrated in FIG. 10, the output element 90 outputs a display 901 of the information on the type of the secondary battery 110 of the processing target, a display 903 of the information on the manufacturer, and a display 905 of the information on the on-board device, which are estimated by the information processing element 50 in the above processing (FIG. 7/S130) to end the series of processing. In a case where the on-board device estimation processing is omitted, the display 905 of the information on the on-board device is not output.

### <Other modified embodiments>

Although the examples of the modified embodiments of the present invention are described above, the present invention is not limited thereto. Various other changes may be made without departing from the spirit of the present invention.

For example, in the above description, an example in which a learned determination model obtained by performing machine learning on the learning data is used as the second correspondence relationship data is described, but the present invention is not limited to this. That is, for example, the second correspondence relationship data may be a determination model that compares the reference data indicating a time-series change of the first voltage value and the second voltage value at the predetermined time, which corresponds to each type of the secondary battery recorded in the first correspondence relationship data, with the first voltage value and the second voltage value at the predetermined time acquired from the secondary battery 110 of the processing target, and determines the type of the secondary battery 110 of the processing target based on the degree of approximation. In this case, the reference data is also stored in the storage element 30 in advance.

In this case, the processing content of the second estimation processing is, for example, as follows. That is, for example, in a case where the first voltage value of the secondary battery 110 of the processing target is 3.5 [V], the information processing element 50 acquires the reference data of the type of the battery in which the first voltage value is 3.5 [V] or in the vicinity thereof from the reference data. In the present example, it is assumed that the reference data in which the first voltage value is 3.5 [V] can be acquired for the LFP and the LCO.

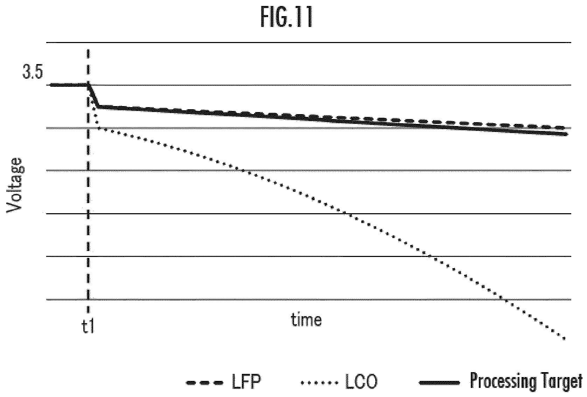

FIG. 11 is a graph illustrating the reference data of the LFP and the LCO acquired in this way, and the first voltage value and the second voltage value of the secondary battery 110 of the processing target. A broken line indicates a change in a voltage value between the first voltage value and the second voltage value of the LFP, a dotted line indicates a change therein of the LCO, and a solid line indicates a change therein of the secondary battery 110 of the processing target.

That is, for example, in the present example, for the LFP, the second voltage value is temporarily decreased compared to the first voltage value, and then gradually decreased. On the other hand, for the LCO, the second voltage value is decreased more than the decrease of the LFP compared to the first voltage value, and then decreases with a steeper curve than the LFP. Then, the change in the voltage value between the first voltage value and the second voltage value of the secondary battery 110 of the processing target is close to the aspect of the change in the LFP.

The determination model which is the second correspondence relationship data receives the reference data of the LFP and the LCO acquired as described above, and the first voltage value and the second voltage value of the secondary battery 110 of the processing target as inputs, and is determined by calculating or the like using a predetermined algorithm, a value of a degree of approximation between the first voltage value and the second voltage value of the secondary battery 110 of the processing target, and each of the reference data of the LFP and the LCO, and outputs the type of the secondary battery corresponding to the reference data having a high degree of approximation. Then, the information processing element 50 estimates that the type of the secondary battery output by the determination model in this way is the type of the secondary battery 110 of the processing target.

That is, in the present example, the information processing element 50 estimates that the type of the secondary battery 110 of the processing target is the LFP.

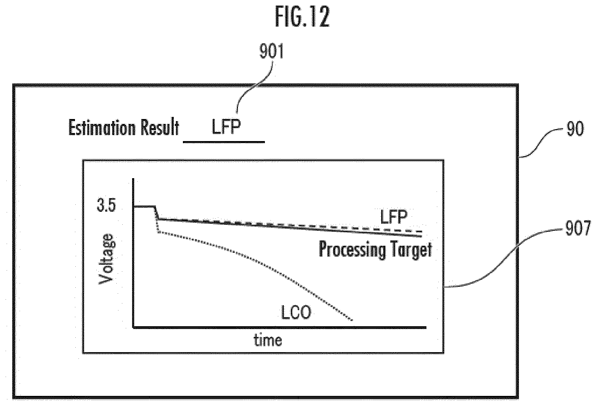

FIG. 12 illustrates an example of the output content of the estimation result. The output content includes the display 901 of the information on the type of the secondary battery 110 of the processing target estimated in the above processing by the information processing element 50. Alternatively, for example, as illustrated in FIG. 12, a graph 907 illustrating the content of the reference data corresponding to each type of the secondary battery to be compared in the estimation processing and the first voltage value and the second voltage value of the secondary battery 110 of the processing target may be further displayed. In this manner, it is possible to improve the operator's sense of convincingness for the estimation result.

### Description of Reference Numerals

10: data acquisition element
30: storage element
50: information processing element
70: reception element
90: output element
110: secondary battery

## Claims

1. A secondary battery information output device comprising:
a data acquisition element configured to acquire charging and discharging data configured of data of a first voltage value before charging or before discharging and data of a second voltage value after start of charging or discharging of a secondary battery of a processing target;
a storage element configured to store first correspondence relationship data indicating a correspondence relationship between the first voltage value of the secondary battery and a type of the secondary battery, and second correspondence relationship data indicating a correspondence relationship between a change in a voltage value between the first voltage value and the second voltage value of the secondary battery, and the type of the secondary battery;
an information processing element configured to estimate the type of the secondary battery of the processing target based on the charging and discharging data, the first correspondence relationship data, and the second correspondence relationship data; and
an output element configured to output an estimation result of the information processing element, wherein
the information processing element is configured to
execute first estimation processing of estimating the type of the secondary battery of the processing target based on the data of the first voltage value of the secondary battery of the processing target and the first correspondence relationship data, and
further execute second estimation processing of estimating the type of the secondary battery of the processing target based on the change in the voltage value between the first voltage value and the second voltage value, and the second correspondence relationship data, when the type of the secondary battery of the processing target is not able to be uniquely estimated in the first estimation processing.

2. The secondary battery information output device according to Claim 1, wherein
the storage element stores manufacturer data indicating a correspondence relationship between the type of the secondary battery and a manufacturer of the secondary battery,
the information processing element estimates the manufacturer of the secondary battery of the processing target based on the estimated type of the secondary battery of the processing target and the manufacturer data, and
the output element outputs information on the manufacturer of the secondary battery of the processing target estimated by the information processing element.

3. The secondary battery information output device according to Claim 2, further comprising:
a reception element configured to receive an operation of an operator of the secondary battery information output device, wherein
the output element outputs information on a plurality of the manufacturers estimated by the information processing element when the information processing element is not able to uniquely estimate the manufacturer of the secondary battery of the processing target, and
the information processing element
receives an operation of the operator to select one manufacturer from the plurality of manufacturers via the reception element, and
estimates that the manufacturer that is received is the manufacturer of the secondary battery of the processing target.

4. The secondary battery information output device according to Claim 2, wherein
the storage element stores on-board device data indicating a correspondence relationship between the manufacturer of the secondary battery and an on-board device of the secondary battery,
the information processing element estimates the on-board device of the secondary battery of the processing target based on the estimated manufacturer of the secondary battery of the processing target and the on-board device data, and
the output element outputs information on the on-board device of the secondary battery of the processing target estimated by the information processing element.

5. The secondary battery information output device according to Claim 4, further comprising:
a reception element configured to receive an operation of an operator of the secondary battery information output device, wherein
the output element outputs information on a plurality of the devices estimated by the information processing element when the information processing element is not able to uniquely estimate the on-board device of the secondary battery of the processing target, and
the information processing element
receives an operation of the operator to select one device from the plurality of devices via the reception element, and
estimates that the device that is received is the on-board device of the secondary battery of the processing target.
